(19) Europäisches Patentamt
European Patent Office
Office européen des brevets

(11) **EP 2 530 836 A1**

(12) **EUROPEAN PATENT APPLICATION**

(43) Date of publication:
**05.12.2012 Bulletin 2012/49**

(51) Int Cl.:
*H03H 9/02* (2006.01)    *H03H 9/08* (2006.01)
*H03H 9/10* (2006.01)    *H03H 9/24* (2006.01)

(21) Application number: **11168330.6**

(22) Date of filing: **31.05.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **IMEC**
**3001 Leuven (BE)**

(72) Inventors:
• **Donnay, Stephane**
  **3020 Herent (BE)**
• **Rottenberg, Xavier**
  **1030 Schaarbeek (BE)**

• **Borremans, Jonathan**
  **2500 Lier (BE)**
• **Tilmans, Hendrikus**
  **3630 Maasmechelen (BE)**
• **van der Plas, Geert**
  **3000 Leuven (BE)**
• **Pertijs, Michiel**
  **2622 AT Delft (NL)**

(74) Representative: **Sarlet, Steven Renaat Irène et al**
**Gevers**
**Intellectual Property House**
**Holidaystraat 5**
**1831 Diegem (BE)**

(54) **Oven controlled MEMS oscillator**

(57)    A system for generating an output signal having a substantially stable frequency, the system comprising: an oven (2); a micromechanical oscillator (11) inside the oven, provided for oscillating at a predetermined frequency; an excitation mechanism associated with the micromechanical oscillator and being configured for exciting the micromechanical oscillator; a temperature control loop (71,83,84,88) associated with the micromechanical oscillator and comprising components (61,62) for detecting, evaluating and adapting the temperature of the micromechanical oscillator (11) according to a ratiometric principle with resistive sensing; a frequency output (87) for outputting the predetermined frequency of the micromechanical oscillator (11) as a basis for generating the output signal; said components may have a first resp. second temperature dependent characteristic, the second temperature dependency being different from the first temperature dependency such that the first and second characteristics intersect within a predetermined temperature range.

Fig. 6

EP 2 530 836 A1

## Description

## TECHNICAL FIELD

The present invention relates generally to systems comprising an oven controlled MEMS oscillator.

## BACKGROUND ART

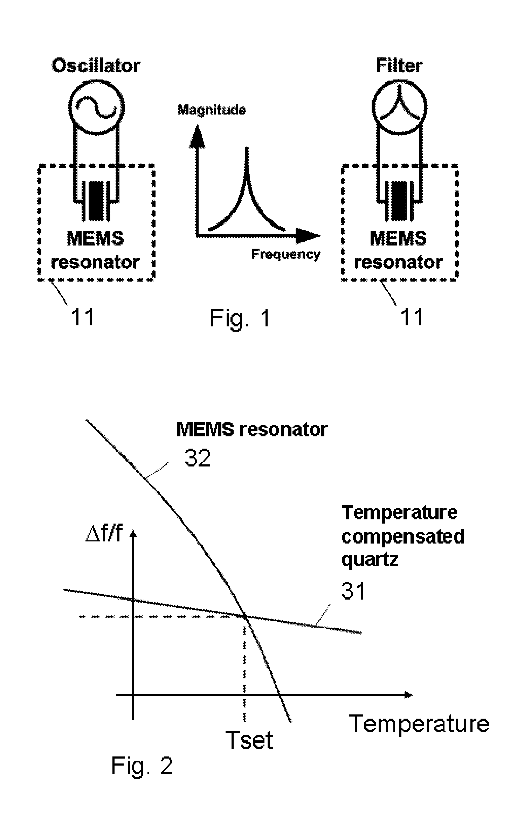

It is known that Micro-electromechanical systems (MEMS) and in particular MEMS resonators possess a very high quality factor (Q), and can be used to build oscillators, which makes them viable to serve as frequency reference devices, as illustrated in Fig 1. Traditionally however quartz crystals are often used as a frequency reference because of their better temperature stability. When higher stability is required, such as in broadcast transmitter systems, an oven controlled crystal oscillator is often used. However, such quartz device is large and a system using a quartz reference suffers from a low level of integration. MEMS oscillators on the other hand are small, and can be integrated, thus lowering the cost significantly. However, MEMS resonators without compensation show a high sensitivity of frequency drift over temperature (e.g. +-5000 ppm over a 100°C ambient temperature range), and thus have a less stable frequency characteristic over temperature than a quartz crystal, as illustrated in Fig 2.

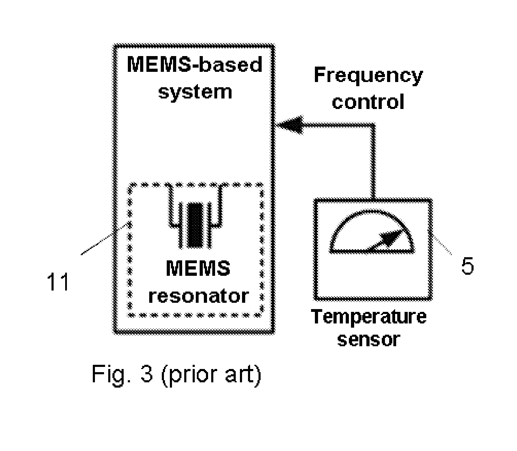

A MEMS resonator can be stabilized better over a wide ambient temperature range (e.g. a 100°C ambient temperature range) by sensing the ambient temperature, and by compensating the MEMS resonator e.g. electrically, depending on the measured temperature. Fig 3 illustrates such a prior art solution. The ambient temperature is sensed by an external temperature sensor in good thermal contact with the MEMS device, and the MEMS oscillator system is compensated electrically by a frequency control means based on the measured temperature. In other words, an ambient temperature sensor drives a frequency compensation knob of the resonator system. In this way the MEMS resonator may typically be controlled up to +-100 ppm accuracy over a 100°C ambient temperature range (e.g. from -20°C to +80°C ambient temperature).

A problem however with these mechanisms is the accuracy and temperature stability of the temperature sensors themselves. Their own drift over temperature limits the achievable temperature stability of the MEMS resonator, which is why a reliable (and expensive) temperature reference is often needed in such systems. Another limitation is the limited thermal contact between the resonator and the temperature sensor, limiting the possible achievable correction.

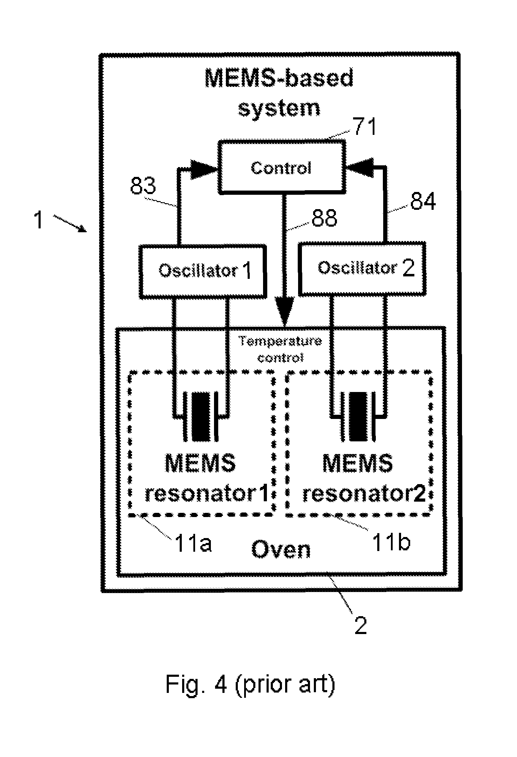

Patent application US 2009/0243747 uses two resonators in an oscillator configuration to generate one stable frequency, as shown in Fig 4. Temperature stability is achieved by using two resonators having a different temperature coefficient of frequency, TCF = $\Delta f/f.1/\Delta T$, being the variation of the frequency per temperature variation, and by compensating for the frequency difference between the resonators due to temperature drift. A predetermined temperature Tset exists where both frequencies are identical (if no compensation was applied). The control loop compensates for the temperature variations and ensures the frequencies are maintained identical also for other temperatures. Therefore, stability of the resonator frequency is achieved. This concept however has the disadvantage of requiring two resonators with a different temperature coefficient of frequency (TCF), requiring a lot of device-area. Also, both resonators should be configured as oscillators, requiring additional circuitry. Also, to achieve the desired frequency, the temperature at both resonator bars should be identical, which may be conceptually easy by matching the designs, but in practice very hard to guarantee. Finally, parasitic coupling between both devices results in a not so clean clock output.

## DISCLOSURE OF THE INVENTION

It is an aim of the present invention to provide a MEMS-based system for generating an output signal at a substantially stable frequency with which a reduced frequency drift can be achieved.

This aim is achieved according to the present invention with the system comprising the technical characteristics of the first claim.

In particular, it has been found that in order to minimize the frequency drift of the system, a ratiometric temperature control loop is needed, which is associated with said micromechanical oscillator and comprises components for detecting, evaluating and adapting the temperature of the micromechanical oscillator according to a ratiometric principle with resistive sensing, and which is furthermore provided for maintaining the temperature of the micromechanical oscillator within a predetermined temperature range around said predetermined set temperature, said predetermined temperature range being determined on the basis of said properties of said micromechanical oscillator and said temperature dependency of said frequency.

The system of the invention has the advantage that it is self-referenced, i.e. no external reference source for the temperature or the frequency is needed for its operation or to limit the frequency drift. Since only the relative temperature error needs to be detected (i.e. detect whether the actual temperature is greater or smaller than the desired temperature), no absolute measure of the amplitude of the error needs to be detected. Therefore, no amplifier nor analog-to-digital converters are needed, which would have needed highly accurate and stable characteristics over temperature. This greatly simplifies the system, rendering it more feasible. Gain errors in detection of the temperature error are irrelevant for achieving the wanted Tset, since the only relevant measure is 'too high' or 'too low', not exactly how much too high or too low.

The system of the invention has the advantage that it can be low power, since the MEMS oscillator is located in the oven and thus shielded from the environment and furthermore since the need for a reference MEMS oscillator in the oven (like in dual resonator system described in US 2009/0243747) can be avoided.

In preferred embodiments, the predetermined temperature range is selected to be at most 0.10 °C, which is possible with the ratiometric temperature control loop of the invention and which can reduce the frequency drift to only a few ppm or less.

The frequency/frequencies at which the micromechanical oscillator oscillates (the oscillator may be designed for oscillating in different modes/frequencies) is/are determined by the properties of the micromechanical oscillator, which comprise a.o. the material in which it is constructed, its topology (shape, layout) and its dimensions.

A preferred material is silicon germanium, which has a TCF (temperature coefficient of frequency) of -40ppm/°C. With the control loop of the invention and a predetermined temperature range restricted to 0.05°C, the frequency drift can be restricted to 2 ppm. On top of this, the design properties can be optimised to achieve an even better stability. As a result, with the ratiometric control loop with resistive sensing in combination with for example a silicon germanium oscillator, a frequency drift of 1 ppm or less can be achieved.

Another possible material is silicon, which has a TCF of - 30ppm/°C. In order to restrict the frequency drift to 2 ppm, a temperature range of 0.067°C can be set in the control loop. Again, the drift can be further reduced by design on the properties of the oscillator. Note that the MEMS oscillator may also be constructed in other suitable materials integratable on a substrate known to the person skilled in the art.

In preferred embodiments, the micromechanical oscillator is a bulk acoustic resonator. Alternatively, the micromechanical oscillator may also be a surface acoustic resonator, a flexural resonator, or any other resonator known to the person skilled in the art.

In preferred embodiments, the micromechanical oscillator is suspended by means of clamped-clamped beams, preferably in a vacuum-sealed package, each beam comprising two support legs with a common connection to the micromechanical oscillator. Using such beams as support anchors for the resonator has the advantages that thermal insulation of the resonator can be enhanced, e.g. by making each leg of the beam acoustically long with respect to the flexural wavelength at which the beam oscillates as a result of the oscillation of the micromechanical oscillator (e.g. each leg longer than a multiple of the flexural wavelength). In particular, it has been found that with such support anchors, power consumption of the single MEMS oscillator system can be below 1 mW, so that a power consumption for the whole system can be reduced to 10 mW or less. Furthermore, the length of the legs can be optimized in order to avoid that the quality factor of the oscillator is affected.

Furthermore, one or more of these beams can be used as heating resistance for heating the micromechanical oscillator, i.e. as part of the control loop.

However, the oscillator can also be suspended by any other support anchors known to the person skilled in the art.

The heating for the oscillator, as part of the control loop, can further comprise a radiation source for heating the micromechanical resonator by means of radiation, or any other heating mechanism known to the person skilled in the art.

The resistive sensing of the ratiometric temperature control loop is preferably provided by using two sensing elements in sufficiently good thermal contact with the micromechanical resonator, such that they have substantially the same temperature as the resonator. The ratiometric principle can be provided in that both sensing elements have different temperature dependent characteristics such that when measured the measurement curves intersect in a predefined intersection point corresponding to the predefined set temperature $T_{set}$. In this way, it is possible to easily determine if the actual temperature of the oscillator is above or below or equal to predetermined temperature $T_{set}$, and controlling the loop correspondingly. Preferably, but not necessarily, the first resp. the second sensing elements are sensed with a first resp. second sensing signal, which are preferably identical, meaning e.g. that the sensing signals have substantially the same amplitude, but not necessarily the same sign or phase or duration.

In an embodiment the control circuit is adapted for subtracting the first and the second measurement signals, resulting in a difference signal, and for amplifying the difference signal, and for providing the amplified difference signal as the control signal.

Optionally the system further comprises a post-compensation circuit for removing residual errors in the system, the post-compensation circuit being connected to the control circuit for receiving its control signal and having components for generating a post-compensation signal, e.g. as a linear or quadratic or polynomial transformation of the control signal, or e.g. using a look-up table, and connected back into the system for supplying the post-compensation signal as a bias signal or an offset signal for reducing the difference between the temperature of the integrated electrical component and the predefined temperature.

By using such a post-compensation circuit residual errors, e.g. caused by inaccuracies due to offsets or due to thermal latency or due to other non-idealities may be further reduced.

## BRIEF DESCRIPTION OF THE DRAWINGS

The invention is further elucidated in the appending figures and figure description explaining preferred embodiments of the invention. Note that the figures are not drawn to the scale. The figures are intended to describe the principles of the invention. Further embodiments of the invention can use combinations of the different features and elements of the different drawings.

Fig 1 shows a MEMS resonator applied in an oscillator and filter.

Fig 2 shows a plot of typical frequency drift over temperature of an oven controlled quartz crystal and for an uncompensated MEMS resonator.

Fig 3 shows a prior art MEMS based system.

Fig 4 shows another prior art MEMS based system.

Fig 5A shows a top view of a typical MEMS oscillator structure without sensing resistors which is used in embodiments according to the invention.

Fig 5B shows a top view of the MEMS oscillator of Fig 5A, on top of which sensing resistors having different TCR's are placed in close proximity and good thermal contact with the MEMS oscillator, in embodiments according to the invention.

Fig 5C shows a cross section of the structure of Fig 5B, according to line A-A, whereby the sensing resistors are placed next to each other.

Fig 5D shows an alternative cross-section, whereby the sensing resistors are placed on top of each other.

Fig 5E shows a vacuum package comprising a MEMs oscillator according to an embodiment of the present invention.

Fig 6 shows an embodiment of the system according to the present invention.

Fig 7A shows an example of measurement voltage signals corresponding to temperature dependent resistor values.

Fig 7B shows the difference between the measured voltage signals of Fig 7A.

Fig 7C shows the output of a comparison between the measured voltage signals of Fig 7A.

Fig 8 shows an embodiment of the system according to the present invention, showing also the heater.

Fig 9 shows a first and a second temperature dependent characteristic.

Fig 10 shows the system of Fig 8 with a post-compensation control loop added.

Fig 11 gives an impression of the stability of an output signal for an oven controlled MEMS oscillator without dual sensor control, with dual sensor control according to embodiments of the present invention, and with dual sensor and post-compensation control according to embodiments of the present invention.

Fig 12 shows an embodiment of Fig 10 whereby the post compensation signal is a bias voltage of the MEMS structure.

Fig 13 shows another variant of Fig 10 whereby the post compensation signal acts upon a phase locked loop.

Fig. 14A-C shows displacement of an oscillating micromechanical oscillator suitable for use in embodiments according to the invention.

Figure 15 shows a schematic drawing of a bulk acoustic longitudinal oscillator heated by radiation, which can be used in embodiments of the invention.

Figure 16 shows measurement data for a 100x100 $\mu$m SiGe oscillator showing the frequency change versus the incident light power on the resonator, according to an embodiment of the invention.

Figures 17 and 18 show embodiments of flexural resonators suitable for use in a system according to the invention.

Figure 19 shows an embodiment of a micromechanical oscillator wherein the oscillator is heated by Joules heating via the supports.

Figure 20 shows an embodiment of a micromechanical oscillator upon which two resistors with 4-point access lines have been laid to measure the

resistance of the part on top of the oscillator, irrespective of the resistance and temperature of the access lines.

## Modes for carrying out the invention

The present invention will be described with respect to particular embodiments and with reference to certain drawings but the invention is not limited thereto. The drawings described are only schematic and are nonlimiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present invention, the only relevant components of the device are A and B.

The present invention provides a system for stabilizing a temperature of a micro-electromechanical (MEMS) oscillator 11 at a predefined temperature $T_{set}$. MEMS structures 11 are generally known, and are used for a wide variety of applications, such as pressure sensors, oscillators, stress sensors, etc. One of their biggest advantages is that they are small and can be integrated in e.g. CMOS chips.

A problem with MEMS structures 11 however is that their characteristics may heavily drift with temperature, which is for example the case with a MEMS oscillator the frequency of which may drift e.g. with 5000 ppm in a 100°C temperature range (e.g. from -20°C to +80°C). For example, a silicon based MEMS oscillator typically has a -30ppm/°C sensitivity to temperature with respect to its resonance frequency $f_{res}(T)$. It is said that its temperature coefficient of frequency TCF is -30ppm/°C.

There are several techniques for stabilizing the frequency of a MEMS oscillator 11, one is by electrical compensation, e.g. by modifying the feedback signal of the oscillator circuit (not further discussed herein), another is by keeping the temperature $T_{comp}$ of the MEMS structure 11 stable at a predefined temperature $T_{set}$. The latter can e.g. be done by placing the MEMS structure 11 in an oven 2 and by maintaining the oven temperature Toven, the latter however requires some means of determining if the temperature inside the oven is higher or lower than the predetermined value $T_{set}$. In the patent application US 2009/0243747 the latter is implemented by using two MEMS resonators having a different Temperature Coefficient of Frequency TCF1, TCF2, and to generate a control signal 88 based on mixing the frequencies (see Fig. 4).

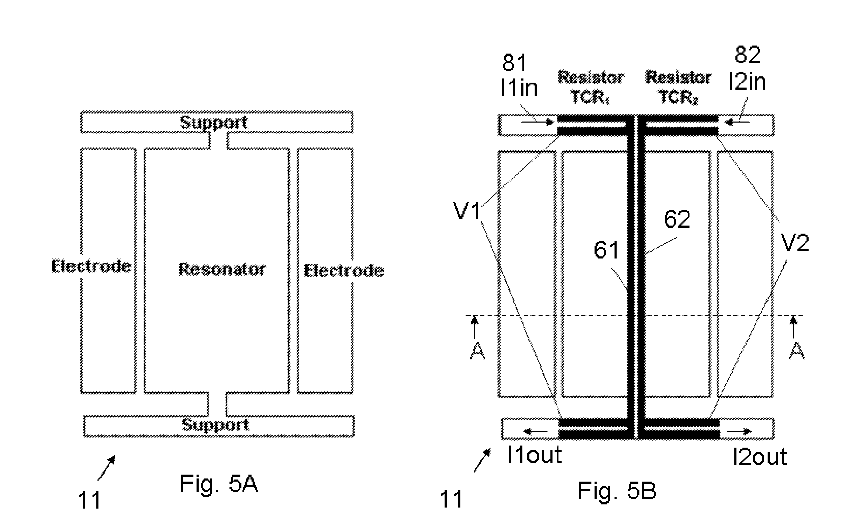

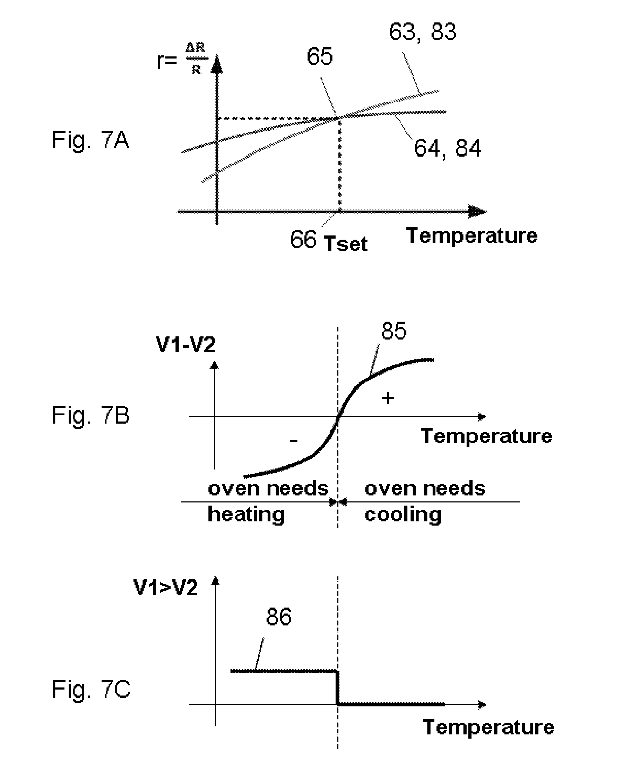

Referring to Fig 5B, according to an embodiment of the present invention at least two resistors 61, 62 having a first resp. second resistance value r1, r2 and having a temperature coefficient of resistance TCR1 resp. TCR2, are processed on top of the resonator bar of a MEMS resonator 11 in an electrically insulated way, but in good thermal contact thereto, sufficient for the desired accuracy of the system. The resistance values are chosen in combination with two sensing signals 81 (I1in), 82 (I2in), e.g. a first DC current 81 running through the first resistor 61 and a second DC current 82 running through the second resistor 62 such that the resulting voltage curves 83, 84 (Fig 7A) intersect in an insection point 85 corresponding to the predefined temperature $T_{set}$. These resistors 61, 62 form an embodiment of the resistive sensing elements used in the ratiometric control loop according to the system of the present invention. In an embodiment the two sensing currents I1, I2 may be substantially the same, e.g. two DC currents generated by a current mirror by circuitry known in the art. In another embodiment a single sense signal (e.g. a DC current I1) may alternatively be applied to the first resp. the second sensing element 61, 62 (e.g. resistor), e.g. using a switch, while the corresponding first resp. second measurement result 83, 84 is stored on a first resp. a second storage means (e.g. measurement capacitors, not shown). After sensing, the measurement signals 83, 84 (e.g. voltages) stored on the storage means may be compared or subtracted for generating the control signal 88. In this way any differences between the first and the second sensing signals 81, 82 can be avoided.

Besides these resistors also other resistive sensing elements may be used, as long as intersecting temperature dependent characteristics 63, 64 can be obtained at the operating temperature, i.e. as long as the control loop is "ratiometric". intersection can be created by simple scaling of the individual characteristics or other operations. For example, it is well known that the resistance of a diode has a substantially exponential dependency on temperature, while the dependency of an electrical resistor is substantially linear, thus the temperature dependency is quite different. For simplicity the principles of the invention will be further described for resistors. For comparison, Fig 5A shows the same MEMS resonator as Fig 5B but without the temperature sensors 61, 62.

Referring back to Fig 5B, in an embodiment the first and second sensing signals 81, 82 are generated by the electrical device 7. They may e.g. be generated in the same chip that comprises the MEMS device 11. In another embodiment the sensing signals 81, 82 are supplied from outside the electrical device 7, e.g. from outside the oven 2. The desired intersection point 65 (Fig 7A) and the corresponding desired temperature $T_{set}$ may be fixed or may be variable or tunable by changing the sensing signals 81, 82. Allowing external sensing signals 81, 82 to be supplied also allows performing some corrections or calibrations.

By placing the two resistors 61, 62 in thermal contact with the MEMS structure 11, in particular to the resonator bar, makes sure that the temperature Tcomp of the resonator bar is as closely as possible matched to the predefined temperature $T_{set}$, during operation of the electrical device 7 (e.g. chip), thereby stabilizing the resonator frequency of this MEMS 11 as good as possible, as the resonator frequency is most sensitive to the local temperature of the resonator bar. Note that during the operation of the electrical device (e.g. chip), there can be a temperature difference between the inside of the oven Toven and the temperature of the MEMS device 11. Therefore the placement of the sensing elements 61, 62 close to the MEMS device is preferred in view of accuracy.

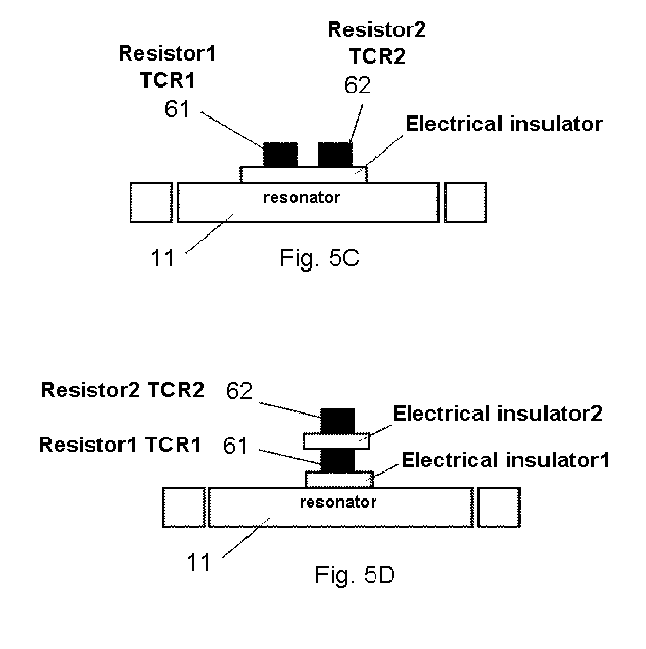

Fig 5C shows a cross section of the structure of Fig 5B, where the sensing resistors 61, 62 are located on an electrical insulator which is placed on top of the resonator. In this way thermal contact but electrical insulation is achieved. Fig 5D shows another embodiment according to the present invention. It is clear to the person skilled in the art that many other topologies can be used.

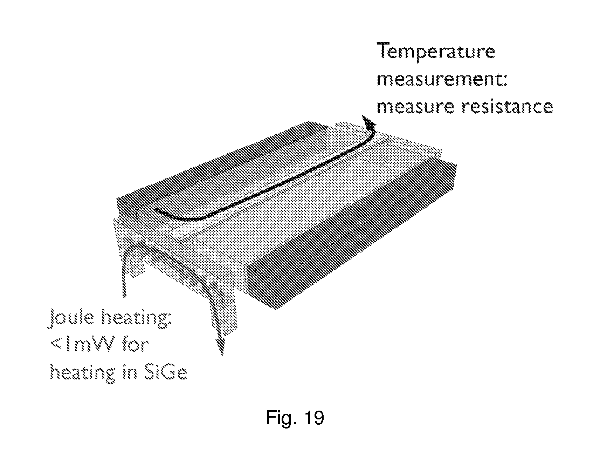

In an embodiment, the oven is a vacuum package 22 containing just the MEMS oscillator 11 and a heating means 21 foreseen in the package. The package 22 provides thermal isolation from the MEMS device 11 to the ambient temperature on the outside of the vacuum package, and together with the heating means 21 forms the oven 2 or ovenized system 1. In a preferred embodiment, the MEMS element 11 can be heated by steering current trough its support legs, heating the MEMS device 11 through Joule heating (see Fig 19). Any other type of heating means 21 can be used, as far as MEMS element 11 and the temperature sensing means 61, 62 are in good thermal contact, that is to say, have substantially the same temperature.

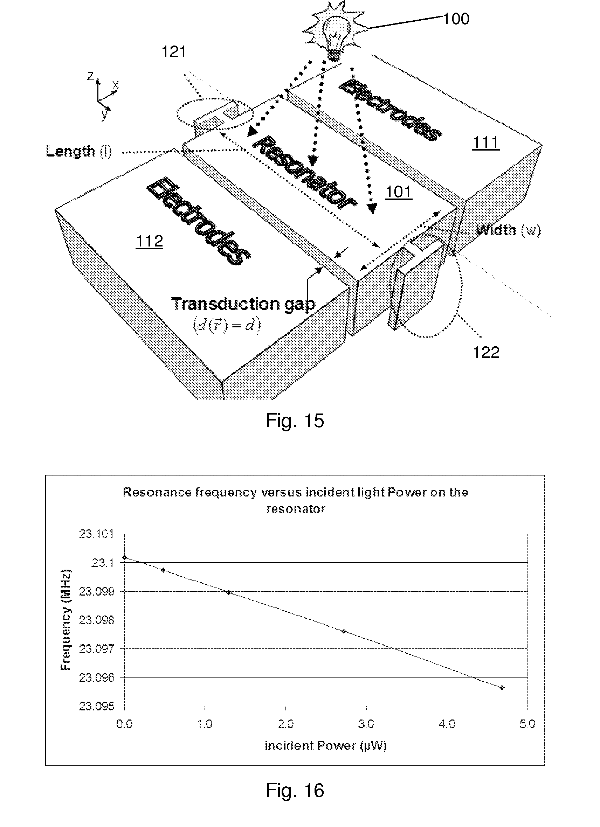

One other example is radiation heating, see Figs 15 and 16. In this embodiment, the heating means comprises a tunable thermal radiation source 100 and the MEM resonating element 101 is provided for absorbing thermal radiation generated by the tunable thermal radiation source. In other words, the MEM resonating element 101 is arranged for receiving thermal radiation emitted by the tunable thermal radiation source 100 while the control circuit is here arranged for monitoring a variation in the temperature of the MEM resonating element by means of resistive sensing elements (not shown), for example on top of the resonating element like in other embodiments described herein. A shift in temperature is monitored by the control circuit which adapts its output signal to the tunable thermal radiation source, for changing the amount of the emitted thermal radiation in relation to the monitored parameter value shift. This can be done by changing the intensity of the emitted thermal radiation, by switching the source on/off intermittently, or otherwise. By providing thermal energy in the form of thermal radiation, the thermal energy can be focused towards the MEM resonating element 101 thereby reducing or even avoiding directly heating the surroundings of the MEM resonating element. As the thermal energy can be more directly absorbed by the MEM resonating element, a much higher reaction speed of the device of the invention to temperature variations can be achieved. The light source 100 can for example be an integrated LED, whose intensity can be adjusted by controlling the LED current supplied to the LED.

Preferably, the resistive sensing elements 61, 62 are placed next to each other or above each other on top, below or next to the MEMS element 11, separated by electrically insulating but thermally conductive layers. Any other implementation providing good thermal contact and not severely deteriorating the MEMS element performance 11 can also be used.

The ratiometric principle may be achieved by using different TCR values, which may in turn be achieved by using two different materials for the resistors 61, 62 required for the dual sensor loop. Fig 7A shows an example of the relative electrical resistance $r = \Delta R/R$ of the first and of the second resistors 61, 62 versus temperature T, or in general the temperature dependent characteristics 63, 64 of the first and the second sensing elements 61, 62.

The existence and production of electrical resistors having predefined TCR values is well known in the art. For example, the temperature coefficient of resistance TCR for n- or p-type silicon depends on the doping concentration, according to known formulas. A. Razborsek and F Schwager describe in "Thin film systems for low RCR resistors" how resistors comprising TaN overlayed with Nipads with adjustable TCR's between -150 ppm/°C and +500 ppm/°C can be produced. US application US7,659,176 describes tunable temperature coefficient of resistance resistors and method of fabricating same. The TCR value of a resistor may vary by using different materials, but resistors comprising the same materials but having different crystal structure or crystal orientation, or a different doping level or impurity level may also have different TCR values.

In the small, predetermined temperature range around $T_{set}$, the curves of the temperature dependent characteristics 63, 64 can be approximated by the formula:

$$R(T) = R_0 (1 + \alpha \, \Delta T) \qquad (1)$$

whereby $\alpha$ is a material characteristic, called the temperature coefficient of resistance, known as TCR. Even though the term "resistor" is used, it is clear to the person skilled in the art that also parallel or series combinations of two or more individual resistors may be used to obtain a combined resistor with a combined resistance value r1 and a combined TCR1 value.

In an embodiment of the present invention using resistors as sensing elements, one of the TCR-values is substantially zero, while the other TCR value is positive.

In another embodiment, one of the TCR-values is substantially zero, while the other TCR value is negative.

In another embodiment, one of the TCR-values is negative while the other TCR value is positive.

In another embodiment, both TCR-values are negative but having a different value.

In another embodiment, both TCR-values are positive but having a different value.

In an embodiment of the present invention, the first and second sensing signals 81, 82 are AC resp. DC currents and the first and second measurement signals 83, 84 are AC resp. DC voltages.

In another embodiment the first and second sensing signals 81, 82 are AC resp. DC voltages and the first and second measurement signals 83, 84 are AC resp. DC currents.

The sensing signals 81, 82 may be continuous signals or intermitted signals.

In an embodiment of the control circuit 71 the measurement signals 83, 84 (e.g. voltages) coming from the sensing elements 61, 62 (e.g. resistors) are subtracted and optionally amplified, yielding for example a difference signal 85 as shown in Fig 7B (or the inverse thereof, depending if the first measurement signal is subtracted from the second or vice versa). Optionally one of the measurement signals 83, 84 can be scaled before the subtraction. When the difference signal 85 of Fig 7B is positive, the temperature Tcomp of the MEMS oscillator 11 is higher than $T_{set}$, and the oven 2 should be cooled, which in case of passive cooling may be achieved by not powering the heater 21. When the difference signal 85 is negative, the temperature Tcomp of the MEMS device 11 is lower than $T_{set}$, and the oven 2 needs to be heated. In practice $T_{set}$ is preferalby chosen at least 10°C above the ambient temperature, so that passive cooling can be used. The actual heating power supplied to the heater 21 may e.g. be proportional to the amplitude of the difference signal 85, or quadratic or exponential or another relationship. In other words, the control loop can for example evaluate by comparing a temperature characteristic (e.g. resistance) of one temperature sensor 61 to a temperature characteristic (e.g. resistance) of a second temperature sensor 62. Via the temperature control loop the oven temperature $T_{oven}$ is driven to the temperature $T_{set}$ where the characteristics intersect (difference of comparison result is zero), such that the output of the MEMS oscillator 11 is tuned to generate a substantially stable output signal. The predetermined temperature range in which the temperature $T_{oven}$ is controlled around $T_{set}$ determines the possible frequency drift of the output signal. By using the ratiometric loop with resistive sensing, the temperature range can for example be restricted to 0.10 °C, leading to a drift of a few ppm or less. The temperature range can be optimised (restricted) towards a target maximum frequency drift of for example 2 or 1 ppm by taking into account the properties of the MEMS oscillator 11 and the temperature dependency of the operating frequency.

In another embodiment the measurement signals 83, 84 are compared to each other, e.g. using a comparator (not shown), yielding for example a comparison signal 86 as shown in Fig 7C. When the signal 86 of Fig 7C is positive, the temperature T of the MEMS device 11 is lower than $T_{set}$, and the oven 2 should be heated. Depending on the comparitor configuration, other comparison signals 86 may be generated, e.g. clipping to a positive or negative voltage, but the person skilled in the art can easily adapt such signal as required by the heating means 21, 100.

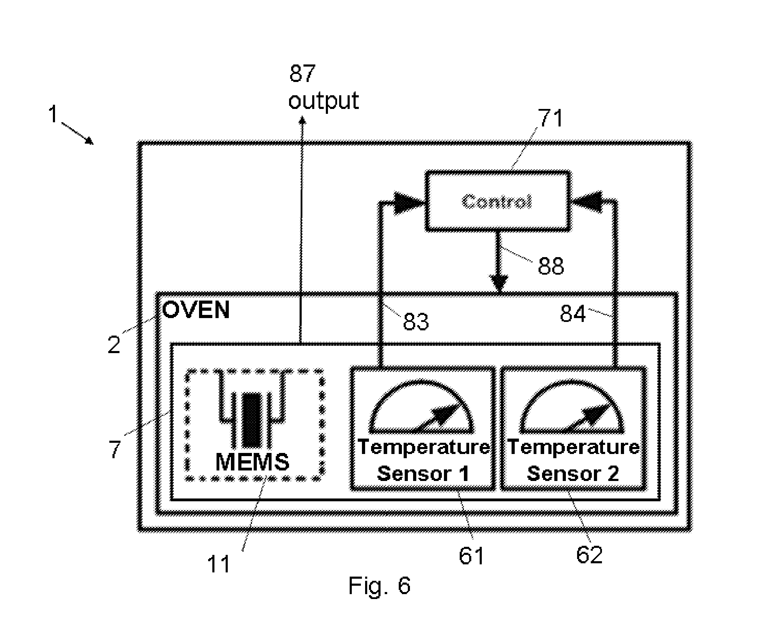

Figure 6 illustrates an embodiment of the system 1 according to the present invention. The control of the oven temperature $T_{oven}$ is based on the ratio or difference of characteristics between two elements 61, 62. The system 1 comprises an oven 2 wherein an electrical device comprising a MEMS device 11 is placed, the electrical device 7 comprising a MEMS structure 11 and two temperature sensors 61, 62 having different temperature dependent characteristics 63, 64 as explained above, for example two resistors R1 and R2 with TCR1 and TCR2 respectively. The system further comprises a control circuit 71 implementing a control loop for controlling or setting the temperature Tcomp of the MEMS structure 11, in particular of an element 11 thereof, to a fixed or desired temperature $T_{set}$. The control circuit 71 may be part of the electrical device 7 or part of the oven 2. The system operates as follows. The variation of the resistance r of each resistor R1, R2 is illustrated in Figure 7A and is noted as functions r1(T) and r2(T). Both resistances are a function of the temperature T. In the temperature range of consideration, there is one (and only one) point where r1(T) and r2(T) are equal. This point is defined by a predetermined temperature $T_{set}$. For this temperature: r1$(T_{set})$=r2$(T_{set})$, which equation is only valid at $T_{set}$, the targeted oven temperature. A control loop controls the oven temperature such that r1$(T_{set})$=r2$(T_{set})$. When this is realized, the temperature of the oven is $T_{set}$, and maintained at $T_{set}$. In fact, $T_{set}$ lies at the intersection of the measurement curves 83, 84 which is the same as the intersection of the characteristic curves when the sensing signals 61; 62 are identical, otherwise the curves are a factor m shifted, m being the ratio of the amplitude of the sensing signals 61, 62.

In steady state operation the temperature of the MEMS device 11 is maintained at $T_{set}$, and the temperature drift is substantially removed. If the control loop has infinite gain at DC (an integrator), this control loop can substantially achieve absolute average temperature accuracy in absence of other circuit non-idealities, such as temperature-dependent offset in the sensing circuitry.

The control loop 71 may be implemented in an analog or digital way, using any algorithm known by the person skilled in the art. Additionally the control loop 71 may provide a circuit for controlling and monitoring the MEMS structures 11 in the oven 2. The control loop can in general contain any element or mechanism needed to effectively operate the system 7 or to tune the output signal 87 (e.g. the frequency of the resonator of the MEMS structure in Fig 6) as desired. In particular, the control loop will ensure that the temperature of the MEMS device 11 is maintained at $T_{set}$. Signal quality factors and parameters of the Mems structure 11 may also be recorded and/or monitored by the control loop. Factors such as thermal variations, noise, elasticity, stress, pressure, applied strain and electrical biases including voltage, electric field and current as well as resonator materials, properties and structure may affect the output of the resonator 11. Monitoring these factors may be useful to develop a relationship between a resonator's output signal's contributing factors and the resonator's output signal characteristics. Understanding these relationships allows one to have more control over the generated output signal 87.

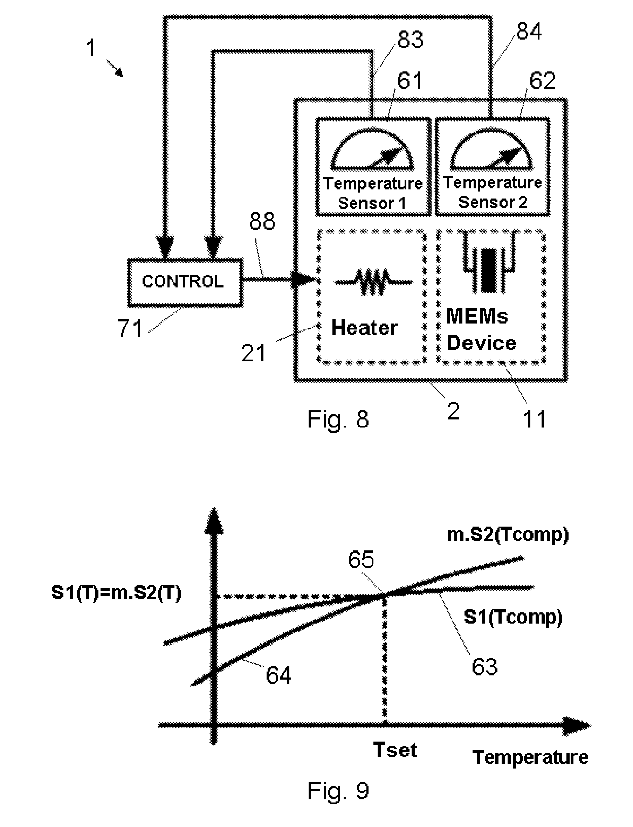

Fig 8 is a variation of Fig 6, showing an ovenized system 1 according to the present invention. The purpose of the first and second sensing element 61, 62 and the control circuit 71 is to keeping the temperature inside the oven 2 stable, equal to $T_{set}$, regardless the ambient temperature. As a result, the component parameter variations will be very small. Two temperature sensors 61, 62 sense the temperature of the MEMS component 11. The sensors 61, 62 have a different dependency on temperature. They output two temperature-dependent values S1 and S2, e.g. measurement voltages V1 and V2 as described above. The control loop 71 drives a heater 21 which controls the temperature Tcomp of the MEMS component 11. The control loop controls the oven temperature such that m*S2=S1, where m is a predefined constant real number. This equation is only valid at one single temperature $T_{set}$. Therefore, when the loop settles, the temperature of the component 11 is $T_{set,}$ and thus its temperature-dependent parameters are stable. This is shown in Fig 9.

It can be observed that the heater control signal 88 can be a function of ambient temperature $T_{amb}$. Indeed, assume that the ambient temperature drops, then the component temperature in the micro-oven 2 will drop too, due to the ambient temperature surrounding the oven 2. Therefore, both S1 and m.S2 will change as well (they may increase or decrease, depending on the sign of the temperature dependency). This will trigger the control loop 71 to compensate the heater control signal 88 to heat up the oven 2 again to the targeted temperature $T_{set}$. Indeed, the loop will force m.S2 back equal to S1. It can be seen from this example that the control signal 74 is a function of the ambient temperature $T_{amb}$. Thus, the dual sensor temperature stabilizing loop 71 can be used as a temperature sensor.

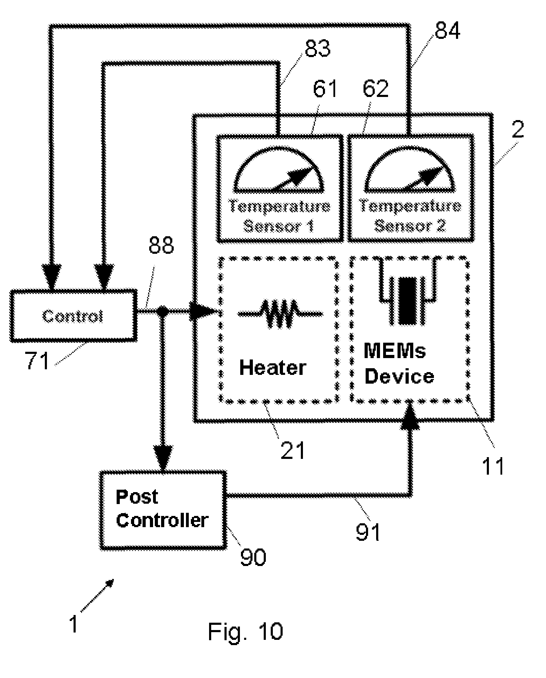

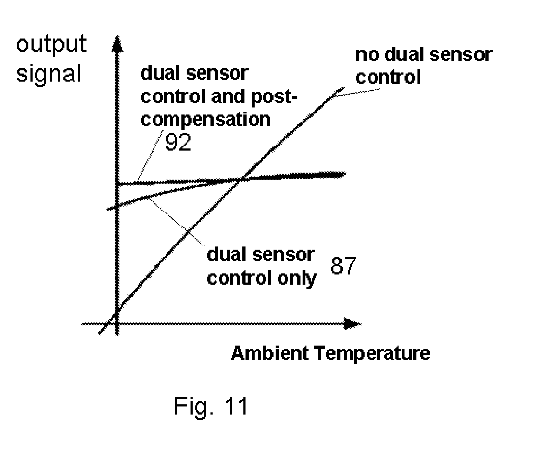

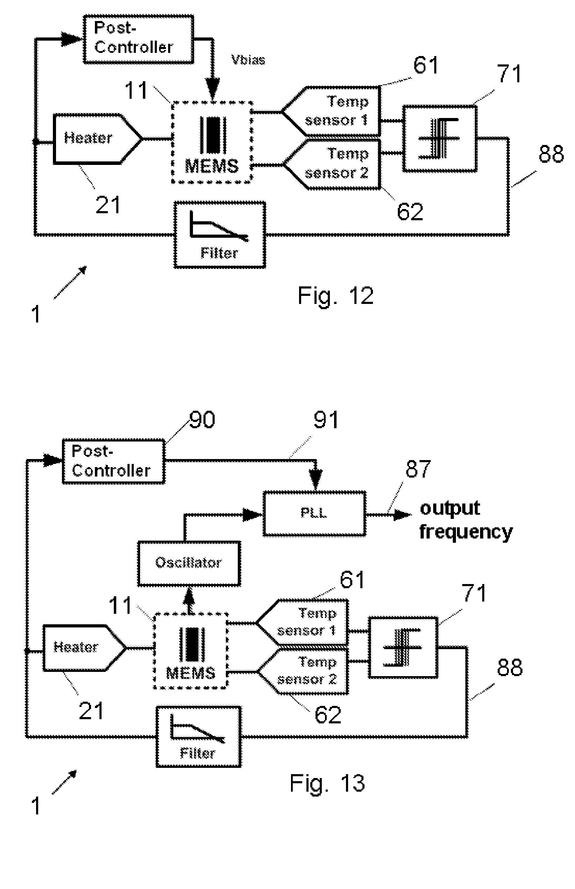

The dual sensor control loop 71, shown in Fig 8, while theoretically perfect, may suffer from non-idealities in practice. This may result in a residual temperature dependency of the heated component parameters (e.g. frequency). In other words, while $T_{set}$ is supposed to be fixed over ambient temperature variations, $T_{set}$ may have a slight residual variation over ambient temperature, as shown in Fig 11 (curve indicated by "dual sensor control only"). This means that the component parameters may still change over temperature, which is undesired. According to another aspect of the present invention, this residual temperature dependence may be further reduced by means of post compensation, as illustrated in Fig 10. In this approach, the ambient temperature $T_{amb}$ needs to be sensed. The measurement of $T_{amb}$ then steers a compensation scheme, which corrects the non-ideal components of the loop. Since the original residual temperature drift due to nonidealities is small, the measurement of $T_{amb}$ does not need not to be very accurate. The post compensation scheme can be of any independent kind which can impact the parameters of interest (e.g. resonator frequency), but not the temperature. For example, the control signal 88, representative for the ambient temperature $T_{amb}$ may steer a bias voltage of the MEMS component 11 (Fig 12). Another embodiment tunes a subsequent PLL (Fig 13) which takes a MEMS oscillator as input and provides a tuned output frequency. This additional compensation 90 can be of any mathematic kind e.g. linear, quadratic or polynomial, or based on a look-up table, or based on any other compensation known by the person skilled in the art. The operation of the post-compensation 90 and the effect on the component parameters or output parameter 92 (e.g. frequency) is illustrated in Figure 11, having a curve which is more flat than the curve 87 corresponding to the system without post-compensation 90.

As mentioned before, the dual sensor loop 71 may be implemented as an analog loop or a digital loop. Therefore, the ambient temperature output $T_{amb}$ can be analog or digital, and the post-compensation scheme 90 can also be analog or digital.

While the post-compensation 90 can control an independent control signal (e.g. bias voltage of the MEMS component 11), it can also act on a temperature loop component. The post-compensation scheme 90 may also act on external parameters, not part of the system. For example, the ambient temperature measurement can serve as post compensation in the external system using the component parameters. For example, the post compensation can be done in an external PLL which uses an ovenized MEMS-based oscillator.

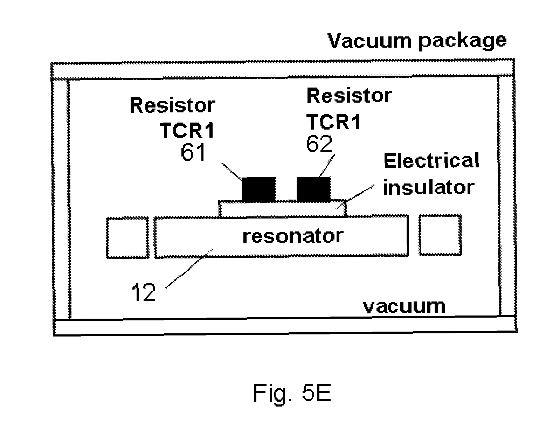

Below, embodiments of MEMS resonator devices for use in systems according to the invention are described with optimal support anchoring for providing frequency and electro-mechanical stability and high Q-factor. The MEMS resonator devices shown in Fig 5, 15 and 19 each time comprise a main resonance body of rectangular shape, but other shapes are possible (e.g. square, circular, parallelepiped, cube, etc). Excitation is achieved by means of electrodes 111, 112 placed at close proximity, i.e. at a transduction gap to the main resonator body 101. The body is suspended above the substrate by means of T-shape supports 121, 122 for anchoring the main resonator body to the substrate.

The T-shaped support or T-support comprises a clamped-clamped beam comprising two legs attached by means of anchors to the substrate, and a common, preferably central connection to the main resonant body 101. The MEMS resonator device or structure is configured to resonate at least in a predetermined mode, for example a breathing mode. The main resonator body resonates at a resonance frequency ($f_{res}$) related to its natural response. The length of the clamped-clamped beams or supports is chosen to be in relation to the flexural wavelength (type of wavelength dependent on most important stress component to support) for providing frequency stability and high Q factor. The T-support design utilizing a rigid clamped-clamped support provides electromechanical stability in the direction of actuation. More in particular, the length $L_{Tsup}$ of each of the beam is chosen as a multiple of half the flexural wavelength plus an offset term.

In these embodiments, each beam is adapted for oscillating in a flexural mode at a given flexural wavelength as a result of said vibration of said resonator body at said operating frequency ($f_{res}$). This means that the properties of the beam are selected such that the beam is made to oscillate in the flexural mode (i.e. exhibits a low stiffness for this oscillation) as a result of the targeted vibration of the resonator body. It has been found that the ability of the beam to oscillate in the flexural mode can enhance or at least maintain electro-mechanical stability of the resonator while an understanding of the flexural mode can be used to optimise the beam design for other parameters. Furthermore each leg is "acoustically long" with respect to said flexural wavelength of the beam vibration, i.e. has a relatively long length with respect to prior art devices, which enhances the thermal insulation of the resonator body. As a result, the resonator can be heated to an operating temperature to keep the operating frequency substantially stable, without significant heat losses towards the substrate. The common central connection is preferably selected or designed to have a minimum length in view of electro-mechanical stability. The minimum length is determined by the design parameters and fabrication process.

Preferably, each leg has a length ($L_{Tsup,opt}$) equal to a predetermined multiple of said flexural wavelength divided by two, plus a predetermined offset, the predetermined multiple being selected in view of optimising thermal resistance of the leg and the predetermined offset being selected in view of optimising the quality factor of the resonator. By selecting one of these lengths for the support legs, the impedance at the connection point of the resonator and the impedance at the anchors are matched. As a consequence, the loss of energy to the substrate via the anchors can be minimized and a resonator device with optimized Q-factor can be provided. Preferably, the predetermined offset is substantially equal to half the length ($L_{cl-cl,1}$) of a clamped-clamped beam with first flexural resonance frequency equal to the operating frequency ($f_{res}$). It has been found that the Q-factor is a periodic function of the support leg length of the resonator and that this predetermined offset substantially corresponds to the maxima of the periodic function.

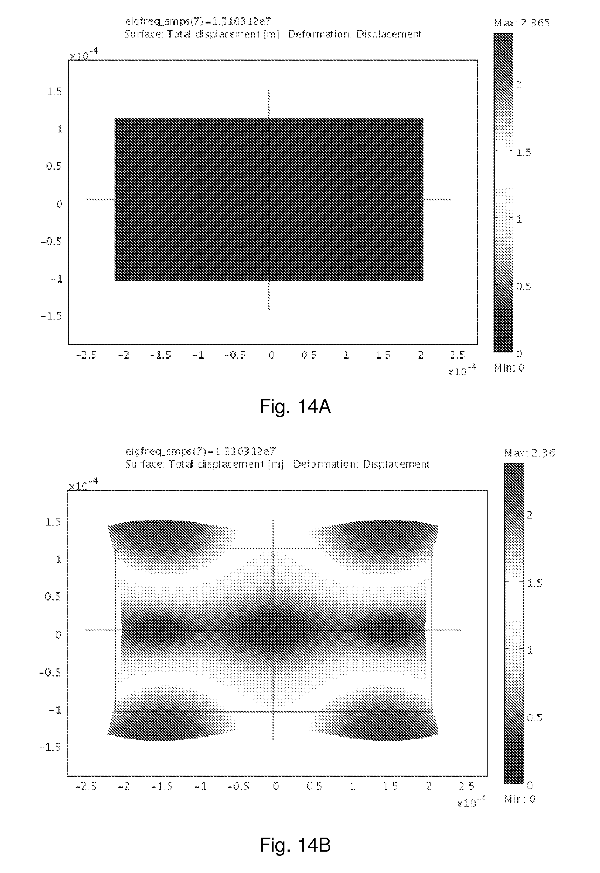

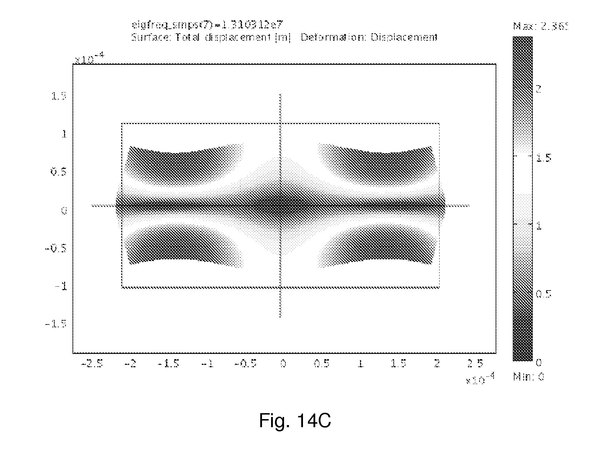

In preferred embodiments, the resonator body is adapted for resonating in a breathing mode which has a symmetry axis where displacement is minimal and wherein the common connections of the clamped-clamped beams are located at said symmetry axis. This means that the beams are connected to the resonator body at points of minimal displacement, which can enhance the electro-mechanical stability of the resonator. Figure 14A-C shows displacement of an oscillating MEMS resonator suitable for use in embodiments according to the invention. The resonator oscillates in a breathing mode, i.e. the body expands and contracts. Figure 14A shows the main body in its original, flat shape, i.e. no displacement. Figure 14B shows the displacement at the point of maximum expansion of the oscillation of the main body: there is substantially no displacement at the longitudinal (central) axis of the body, and maximal displacement along the longitudinal edges of the body. Figure 14C shows the displacement at the point of maximum contraction of the oscillation of the main body: there is likewise substantially no displacement at the longitudinal axis of the body, and maximal displacement along the longitudinal edges of the body. This shows that this longitudinal axis is the best place to connect the supports for this oscillator in this breathing mode.

The high levels of electro-mechanical stability which can be achieved according to the invention further allows large voltages to be applied without the danger of pull-in, thus achieving lower motional impedance of the MEMS resonator which can lead to easier integration.

In preferred embodiments, the clamped-clamped beams are T-shaped, centrally connected to the resonator body. In alternative embodiments, the clamped-clamped beams can also be for example angled beams.

In preferred embodiments, the clamped-clamped beams have a rigid direction, said excitation means being located for exciting the resonator body in the rigid direction of said beams. For example, in the case of T-shaped beams, the rigid direction is the longitudinal direction of the support legs and the beams have a low stiffness in any direction orthogonal thereto.

The invention is however not restricted to micromechanical oscillators which are designed for oscillating in a breathing mode.

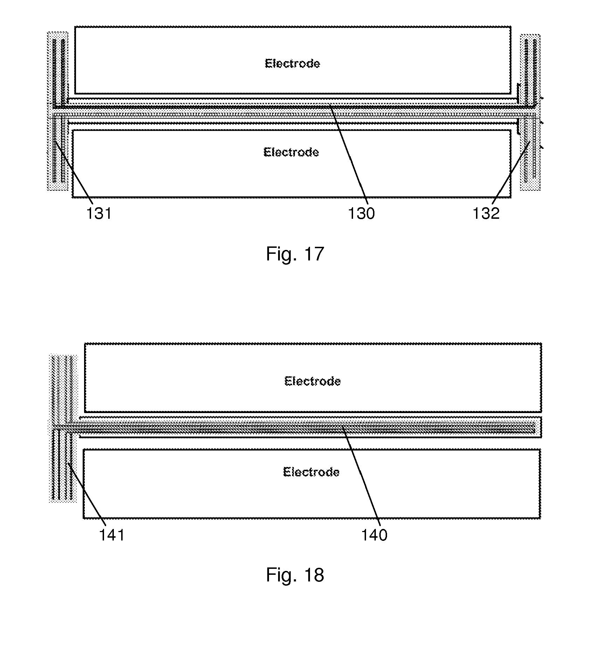

Figure 17 shows an example of a flexural resonator which can be used in embodiments according to the invention. The resonator comprises a clamped-clamped beam 130 extending between two excitation electrodes and adapted for resonating in a flexural mode. The supports 131, 132 can in turn also be clamped-clamped beams with acoustically long legs as described herein. On top of the resonator, two resistive sensing elements are provided in the same way as has been described with reference to figure 5.

Figure 18 shows another example of a flexural resonator which can be used in embodiments according to the invention. The resonator comprises a cantilever beam 140 extending between two excitation electrodes and adapted for resonating in a flexural mode. The support 140 can in turn also be a clamped-clamped beam with acoustically long legs as described herein. On top of the resonator, two resistive sensing elements are provided in the same way as has been described with reference to figure 5.

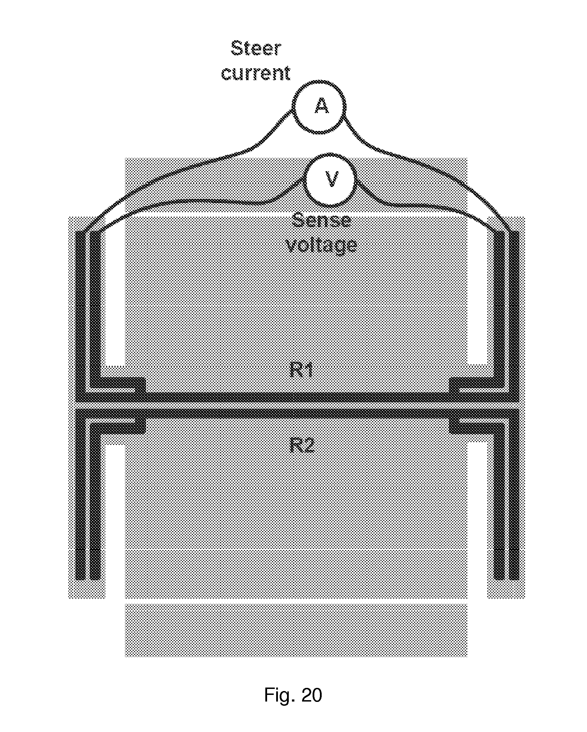

In another preferred embodiment, shown in Fig. 20, two resistors comprised of materials with different TCR are the sensing elements. Kelvin (4-point) connections to the resistor allow measurement of the resistance on the device. In a possible setup, a current A is steered through the resistor, while the voltage V is monitored. The resistance is then V/A, irrespective on the resistance and temperature of the access lines. Other sensing configurations can be applied as well.

## Claims

1. A system for generating an output signal having a substantially stable frequency, the system comprising:

   - an oven;
   - a micromechanical oscillator inside the oven and having predetermined properties for oscillating at a predetermined frequency when at a predetermined set temperature, said frequency having a given temperature dependency;
   - an excitation mechanism associated with said micromechanical oscillator and being configured for exciting the micromechanical oscillator to oscillate at said predetermined frequency,
   - a temperature control loop associated with said micromechanical oscillator and comprising components for detecting, evaluating and adapting the temperature of the micromechanical oscillator according to a ratiometric principle with resistive sensing, the temperature control loop being provided for maintaining the temperature of the micromechanical oscillator within a predetermined temperature range around said predetermined set temperature, said predetermined temperature range being determined on the basis of said properties of said micromechanical oscillator and said temperature dependency of said frequency in order to minimize frequency drift of the system;
   - a frequency output for outputting the predetermined frequency of the micromechanical oscillator as a basis for generating said output signal.

2. A system according to claim 1, wherein the predetermined properties of the micromechanical oscillator comprise a material in which it is constructed, its topology and its dimensions.

3. A system according to claim 1 or 2, wherein the predetermined temperature range is selected to be at most 0.10 °C.

4. A system according to any one of the previous claims, wherein the micromechanical oscillator is constructed in silicon germanium.

5. A system according to any one of the previous claims, wherein the micromechanical oscillator is a bulk acoustic resonator.

6. A system according to any one of the previous claims, wherein the micromechanical oscillator is a flexural resonator.

7. A system according to any one of the previous claims, wherein the micromechanical oscillator is a surface acoustic resonator.

8. A system according to any one of the previous claims, wherein the micromechanical oscillator is suspended by means of clamped-clamped beams, each beam comprising two support legs with a common connection to the micromechanical oscillator.

9. A system according to claim 8, wherein each beam is adapted for oscillating in a flexural mode at a given flexural wavelength as a result of said oscillation of said micromechanical oscillator at said predetermined frequency, each leg being acoustically long with respect to said flexural wavelength of the beam.

10. A system according to claim 8 or 9, wherein each leg is longer than a multiple of said flexural wavelength.

11. A system according to any one of the claims 8-10, wherein at least one of said beams forms a heating resistance as part of said control loop, provided for heating said micromechanical oscillator.

12. A system according to any one of the previous claims, wherein said control loop comprises a radiation source for heating the micromechanical oscillator by means of radiation.

13. A system according to any one of the previous claims, wherein the set temperature is selected at least 10°C above the ambient temperature of the system during normal use.

14. A system according to any one of the previous claims, wherein the excitation mechanism comprises a biasing electrode inside said oven in close proximity to the micromechanical oscillator and connected to a bias voltage source.

15. A system according to any one of the previous claims, wherein the frequency output comprises a sensing electrode inside said oven in close proximity to the micromechanical oscillator.

16. A system according to any one of the previous claims, wherein the temperature control loop comprises a first resp. second resistive sensing element (61, 62) located in good thermal contact with the micromechanical oscillator such that the resistive sensing elements (61, 62) have substantially the same temperature (Tcomp) as the micromechanical oscillator, the first resp. second resistive sensing elements (61, 62) having a first resp. second temperature dependent characteristic (63, 64), the second temperature dependency being different from the first temperature dependency such that the first and second characteristics (63, 64) intersect within said predetermined temperature range.

17. A system according to claim 16, wherein the micromechanical oscillator has a topology with an axis of minimal movement during said oscillation and wherein said resistive sensing elements are provided along said axis.

18. A system according to any one of the previous claims, further comprising a post-compensation circuit (90) for removing residual errors in the system, the post-compensation circuit being connected to the temperature control loop for receiving a control signal (88) therefrom, the post-compensation circuit having components for generating a post-compensation signal (91) as transformation of the control signal (88).

19. A system according to any one of the previous claims, further comprising an output signal generator connected to said frequency output and having components for generating said output signal on the basis of said predetermined frequency.

20. A system according to any one of the previous claims, wherein the oven is a vacuum-sealed package containing only the micromechanical oscillator.

**Oscillator**

**Filter**

Magnitude

Frequency

MEMS resonator

11

MEMS resonator

11

Fig. 1

MEMS resonator

32

$\Delta f/f$

Temperature compensated quartz

31

Tset

Temperature

Fig. 2

MEMS-based
system

Frequency
control

MEMS
resonator

Temperature
sensor

11

5

Fig. 3 (prior art)

Fig. 4 (prior art)

EP 2 530 836 A1

Fig. 5A

Fig. 5B

**Resistor1**
**TCR1**
61

**Resistor2**
**TCR2**
62

**Electrical insulator**

resonator

11

Fig. 5C

**Resistor2 TCR2** 62

**Resistor1 TCR1** 61

**Electrical insulator2**

**Electrical insulator1**

resonator

11

Fig. 5D

Vacuum package

Resistor
TCR1
61

Resistor
TCR1
62

Electrical
insulator

resonator

12

vacuum

Fig. 5E

Fig. 6

Fig. 7A

$r = \frac{\Delta R}{R}$

65

63, 83

64, 84

66 Tset

Temperature

Fig. 7B

V1-V2

85

+

-

oven needs
heating

oven needs
cooling

Temperature

Fig. 7C

V1>V2

86

Temperature

Fig. 8

Fig. 9

Fig. 10

Fig. 11

Post-Controller

Vbias

11

71

61

Temp sensor 1

Heater

MEMS

Temp sensor 2

88

21

62

Filter

1

Fig. 12

90

91

Post-Controller

87

PLL

output frequency

Oscillator

11

71

61

Temp sensor 1

Heater

MEMS

Temp sensor 2

88

21

62

Filter

1

Fig. 13

eigfreq_smps(7)=1.310312e7
Surface: Total displacement [m]   Deformation: Displacement

Max: 2.365

Min: 0

Fig. 14A

eigfreq_smps(7)=1.310312e7
Surface: Total displacement [m]   Deformation: Displacement

Max: 2.36

Min: 0

Fig. 14B

Fig. 14C

Fig. 15

Fig. 16

Electrode

Electrode

131          130          132

Fig. 17

Electrode

Electrode

141          140

Fig. 18

Temperature measurement: measure resistance

Joule heating: <1mW for heating in SiGe

Fig. 19

EP 2 530 836 A1

Fig. 20

29

**EP 2 530 836 A1**

Europäisches Patentamt
European Patent Office
Office européen des brevets

**EUROPEAN SEARCH REPORT**

Application Number

EP 11 16 8330

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | WO 2010/052683 A2 (NXP BV [NL]; KONING JAN JACOB [NL]; VAN BEEK JOZEF THOMAS MARTINUS [NL] 14 May 2010 (2010-05-14)<br>* page 1, line 18 - page 2, line 12; figure 1 *<br>* page 11 - page 16 * | 1-7, 13-20<br><br>12 | INV.<br>H03H9/02<br>H03H9/08<br>H03H9/10<br><br>ADD.<br>H03H9/24 |
| X | US 2007/262831 A1 (VAN BEEK JOZEF THOMAS M [NL] ET AL VAN BEEK JOZEF THOMAS MARTINUS [NL]) 15 November 2007 (2007-11-15)<br>* paragraph [0017] - paragraph [0023]; figures 1,4 * | 1-3,5,6, 13-20 | |
| X | US 2005/195050 A1 (LUTZ MARKUS [US] ET AL) 8 September 2005 (2005-09-08)<br>* paragraphs [0133], [0134], [0163]; figures 5-8, 15, 16 * | 1-6, 13-20 | |
| X | US 2010/315179 A1 (SCHOEPF KLAUS JUERGEN [US] ET AL) 16 December 2010 (2010-12-16)<br><br>* paragraphs [0028], [0063] - [0066]; figures 3-5 * | 1-3,5,6, 13-15, 17-20 | TECHNICAL FIELDS SEARCHED (IPC)<br><br>H03H |
| Y | US 4 259 606 A (VIG JOHN R) 31 March 1981 (1981-03-31)<br>* abstract * | 12 | |

~~The present search report has been drawn up for all claims~~

| Place of search | Date of completion of the search | Examiner |
|---|---|---|
| Munich | 20 October 2011 | Naumann, Olaf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-7, 12-20

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 11 16 8330

The Search Division considers that the present European patent application does not comply with the
requirements of unity of invention and relates to several inventions or groups of inventions, namely:

```
1. claims: 1-7, 12-20

       System comprising a MEMS oscillator with temperature control
       loop and specifics of the temperature control loop.
                         ---

2. claims: 8-11

       In a system of claim 1, a specific type of support structure
       for a MEMS oscillator and modifications thereof
                         ---
```

**EP 2 530 836 A1**

## ANNEX TO THE EUROPEAN SEARCH REPORT
## ON EUROPEAN PATENT APPLICATION NO.

EP 11 16 8330

This annex lists the patent family members relating to the patent documents cited in the above-mentioned European search report.
The members are as contained in the European Patent Office EDP file on
The European Patent Office is in no way liable for these particulars which are merely given for the purpose of information.

20-10-2011

| Patent document cited in search report | | Publication date | Patent family member(s) | | Publication date |
|---|---|---|---|---|---|
| WO 2010052683 | A2 | 14-05-2010 | CN | 102210099 A | 05-10-2011 |
| | | | EP | 2356744 A2 | 17-08-2011 |
| | | | US | 2011215877 A1 | 08-09-2011 |
| | | | WO | 2010052683 A2 | 14-05-2010 |
| US 2007262831 | A1 | 15-11-2007 | AT | 510352 T | 15-06-2011 |
| | | | CN | 1849746 A | 18-10-2006 |
| | | | JP | 2007505543 A | 08-03-2007 |
| | | | KR | 20060119957 A | 24-11-2006 |
| | | | US | 2007262831 A1 | 15-11-2007 |
| | | | WO | 2005025057 A2 | 17-03-2005 |
| US 2005195050 | A1 | 08-09-2005 | CN | 1951009 A | 18-04-2007 |
| | | | EP | 1723720 A1 | 22-11-2006 |
| | | | US | 2005195050 A1 | 08-09-2005 |
| | | | US | 2006033594 A1 | 16-02-2006 |
| | | | WO | 2005096495 A1 | 13-10-2005 |
| US 2010315179 | A1 | 16-12-2010 | NONE | | |
| US 4259606 | A | 31-03-1981 | CA | 1131321 A1 | 07-09-1982 |
| | | | US | 4259606 A | 31-03-1981 |

EPO FORM P0459

For more details about this annex : see Official Journal of the European Patent Office, No. 12/82

33

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090243747 A
- US 7659176 B